Europäisches Patentamt

European Patent Office

Office européen des brevets

(19)

(11) Veröffentlichungsnummer: **0 200 050 B1**

(12) **EUROPÄISCHE PATENTSCHRIFT**

(45) Veröffentlichungstag der Patentschrift: **01.07.92**

(51) Int. Cl.⁵: **H01L 31/02**, H01L 25/04

(21) Anmeldenummer: **86104945.0**

(22) Anmeldetag: **10.04.86**

(54) **Solarmodul mit Eckwinkel.**

(30) Priorität: **17.04.85 DE 3513894**

(43) Veröffentlichungstag der Anmeldung:
**10.12.86 Patentblatt 86/45**

(45) Bekanntmachung des Hinweises auf die
Patenterteilung:
**01.07.92 Patentblatt 92/27**

(84) Benannte Vertragsstaaten:
**AT BE CH DE FR GB IT LI NL**

(56) Entgegenhaltungen:
DE-A- 1 809 159    DE-A- 2 936 764
FR-A- 1 556 758    FR-A- 2 350 695
GB-A- 1 603 980    US-A- 4 392 009

(73) Patentinhaber: **SIEMENS AKTIENGESELL-
SCHAFT
Wittelsbacherplatz 2
W-8000 München 2(DE)**

(72) Erfinder: **Riermeier, Manfred
Finkenweg 1
W-8059 Neuching(DE)**
Erfinder: **Schuber, Viktor
Bertholdstrasse 25/II
W-8000 München 40(DE)**

**Beschreibung**

Die Erfindung betrifft ein Solarmodul nach dem Oberbegriff des Anspruchs 1.

Im wesentlichen sind heute zwei Modultechnologien für die Herstellung von Solarmodulen üblich. Bei der Doppelglas-Technologie, werden Solarzellen zusammen mit ihrer elektrischen Beschaltung zwischen zwei Glasscheiben mit Hilfe von Kunststoff in flüssiger Form oder mit Hilfe von Thermoplast-Folienmaterial eingebettet.

Eine weitere Technologie zur Herstellung von Solarmodulen ist die sogenannte Superstrate-Technik. Dabei wird auf der Vorderseite eines Solarmoduls ebenfalls eine Glasscheibe zur Abdeckung verwendet, während die Rückseite des Solarmoduls aus Kunststoff-Folien, beispielsweise aus aluminiumbeschichteten Folien, aufgebaut ist. Zwischen Vorderseite und Rückseite des Solarmoduls sind wiederum die Solarzellen zusammen mit ihrer elektrischen Beschaltung mit Hilfe von Thermoplast-Folien eingebettet.

Verfahren zur Herstellung von solchen Solarmodulen sind beispielsweise in den US-Patentschriften 4 067 764, 4 224 081, 4 231 807, 4 317 739, 4 433 200 und 4 401 839 angegeben.

Die Rahmung der Solarmodule geschieht meist mit Profilen aus Aluminium oder Stahl, die beispielsweise mit Silikon abgedichtet sind.

DE-A-2 936 764 beschreibt ein Solarmodul, bei dem Bohrungen zur Befestigung des Moduls an den Ecken des Rahmens vorgeshen sind.

Der vorliegenden Erfindung liegt die Aufgabe zugrunde, ein Solarmodul der eingangs genannten Art anzugeben, das langdauernd stabil befestigt werden kann.

Diese Aufgabe wird erfindungsgemäß durch ein Solarmodul nach Anspruch 1 oder 2 gelöst.

Solarmodule gemäß Anspruch 2 können direkt aneinandergrenzend nebeneinander angeordnet werden, ohne daß zwischen äußeren Rahmenelementen der verschiedenen Solarmodule auch nur abschnittsweise ein Abstand bestehen würde. Auf diese Weise kann die pro Fläche einer Unterlage erzeugte Solarenergie optimiert werden.

Ein Solarmodul nach der Erfindung muß nicht notwendig vier Seiten aufweisen. Ein Solarmodul nach der Erfindung kann ein beliebiges n-Eck sein, solange solche n-eckförmig ausgebildete Solarmodule zusammen mit anderen m-eckförmigen Solarmodulen eine Unterlage so belegen können, daß zwischen den einzelnen Solarmodulen, abgesehen von Kantenabrundungen an den Rahmenkanten, kein Zwischenraum verbleibt. Demzufolge muß zwischen den beiden Einrichtungen zur Halterung des Eckwinkels im Solarmodulrahmen auch nicht notwendig ein 90°-Winkel bestehen.

Ein Eckwinkel zwischen zwei aneinandergrenzenden Teilen eines Solarmodulrahmens weist ein Befestigungsloch zum Befestigen des Solarmoduls auf. Zur besseren Belüftung der Unterseite eines Solarmoduls kann ein Solarmodul mit Hilfe von Abstandshaltern an den Befestigungseinrichtungen an den Eckwinkeln so auf einer Unterlage befestigt werden, daß die Rückseite des Solarmoduls einen Abstand zur Unterlage aufweist. Als Abstandshalter können beispielsweise Beilagscheiben auf einem Befestigungsstift an einem Eckwinkel verwendet werden.

Die Einrichtungen zur Halterung des Eckwinkels können in weitere Halterungen von weiteren Befestigungseinrichtungen eingesteckt werden. Diese weiteren Befestigungseinrichtungen befinden sich an den beiden Enden der benachbarten Teile des Solarmodulrahmens. Die weiteren Befestigungseinrichtungen können dabei in das Rahmenprofil der benachbarten Teile des Rahmens eingepreßt werden. Wenn die Einrichtungen zur Halterung des Eckwinkels in weitere Halterungen eingesteckt sind, können die Einrichtungen zur Halterung des Eckwinkels in dieser Lage durch Stellschrauben, die in einer Senke einer Einrichtung zur Halterung des Eckwinkels positioniert werden, oder durch Schrauben, die jeweils in ein Gewinde der Einrichtung zur Halterung des Eckwinkels durch das Rahmenprofil hindurch eingeschraubt werden, fixiert werden.

Die Erfindung wird anhand der Zeichnung näher erläutert:

Die Fig. 1 bis 4 erläutern ein Solarmodul mit einem Eckwinkel mit einem Flansch.

Die Fig. 5 bis 10 erläutern ein Solarmodul mit einer Aussparung.

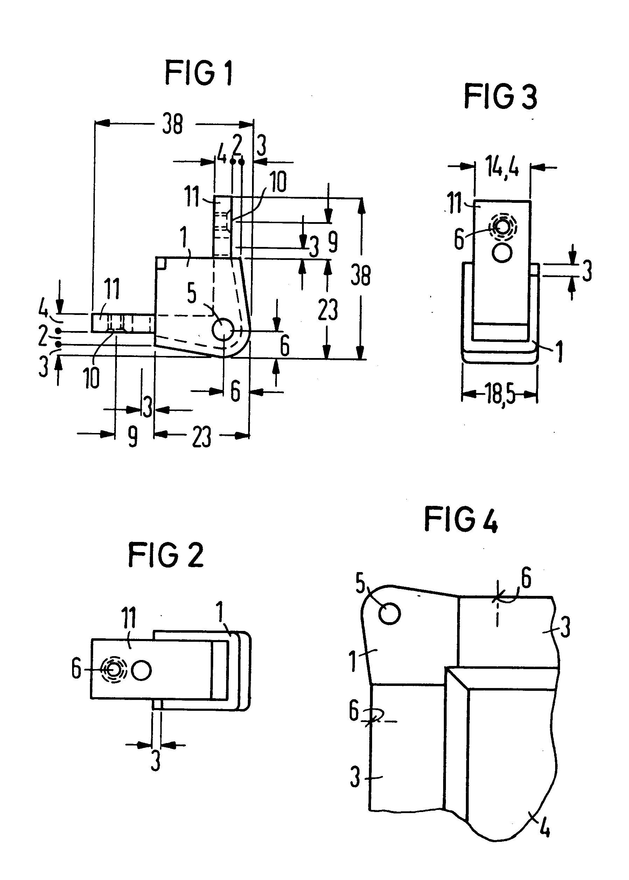

Fig. 1 zeigt in der Draufsicht einen Eckwinkel 1, der einen Flansch mit einem Befestigungsloch 5 und zwei Einrichtungen 11 zur Halterung des Eckwinkels 1 mit jeweils einer Versenkung 10 aufweist. Die Maße dieses Eckwinkels 1 können der Fig. 1 entnommen werden.

Die Fig. 2 und 3 sind bis auf die Tatsache, daß ihre Gegenstände gegeneinander um 90° verdreht sind, gleich. Die Fig. 2 und 3 zeigen zwei Seitenansichten des Eckwinkels 1 nach Fig. 1. Die Einrichtung 11 zur Halterung des Eckwinkels 1 besitzt ein Schraubgewinde 6, durch das hindurch eine Stellschraube in eine Versenkung 10 der Einrichtung 11 zur Arretierung des Eckwinkels 1 geschraubt werden kann. Die Einrichtung 11 wird in ein Teil 3 des Solarmodulrahmens eingesteckt und ebenfalls mit Hilfe der Stellschraube dadurch fixiert, daß das Gewinde der Stellschraube durch eine Bohrung in der Stirnseite des Teils 3 hindurchgeführt wird. Eine Einrichtung 11 kann noch ein weiteres Innengewinde aufweisen, in das zusätzlich eine Schraube durch eine weitere Bohrung an der Stirnseite des Teils 3 hindurch eingeschraubt werden kann.

Die Fig. 4 zeigt einen Teil eines Solarmoduls mit einem Solarmodulverbund 4 und mit einem Eckwinkel 1. Dabei ist deutlich sichtbar, daß der Flansch des Eckwinkels 1 gegenüber dem Rahmen aufträgt und die Außenabmessungen des gesamten Solarmoduls deutlich vergrößert.

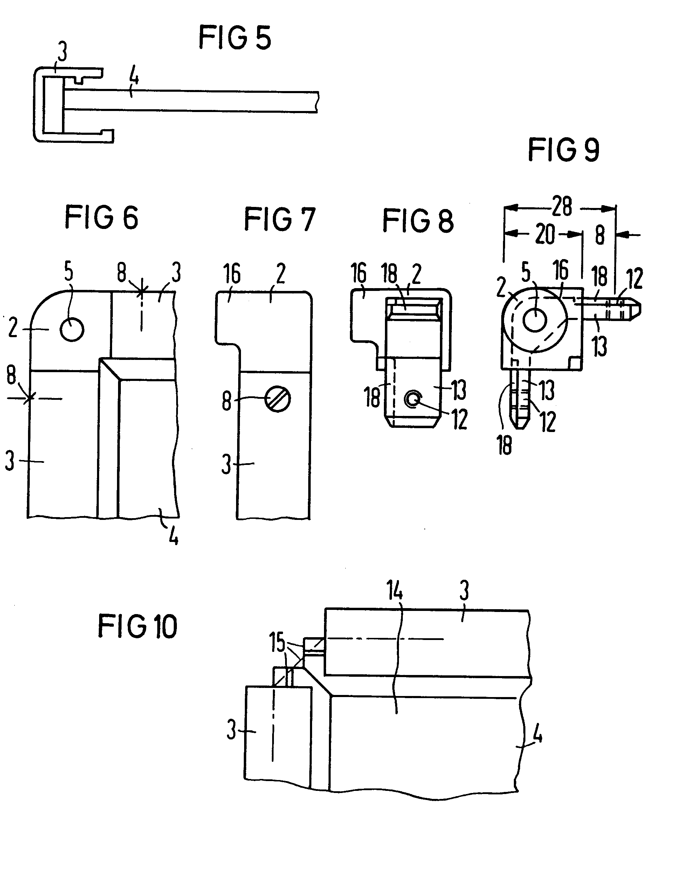

Fig. 5 zeigt einen Querschnitt durch ein Rahmenprofil eines Teils 3 des Rahmens, wie es für die Erfindung verwendet werden kann.

Fig. 6 zeigt in der Draufsicht einen Teil eines Solarmoduls mit einem Eckwinkel 2. Dabei ist deutlich sichtbar, daß dieser Eckwinkel 2 keinen Flansch besitzt und damit nicht gegenüber dem Rahmen aufträgt. Die Außenabmessungen des Solarmoduls mit einem Rahmenprofil nach Fig. 5 bleiben dabei erhalten und werden dabei auch durch Verwendung eines Eckwinkels 2 mit einer Einrichtung zur Befestigung des Solarmoduls nicht vergrößert.

Fig. 7 zeigt einen Gegenstand nach Fig. 6 in einer Seitenansicht. Dabei ist deutlich der Kopf einer Schraube 8 sichtbar, welche durch eine Bohrung in der Stirnseite des Teils 3 des Rahmens hindurch durch ein Gewinde 12 in der Einrichtung 13 zur Halterung des Eckwinkels 2 hindurch zur Fixierung des Eckwinkels 2 geschraubt wird.

Fig. 8 zeigt einen Schnitt durch einen Gegenstand nach Fig. 6 parallel zu derjenigen Ebene, die in Fig. 7 dargestellt ist. Dabei sind die Einrichtungen 13 zur Halterung des Eckwinkels 2 deutlich erkennbar.

Fig. 9 zeigt den Eckwinkel 2. Dabei besitzen die beiden Einrichtungen 13 jeweils ein Innengewinde 12. Anstelle des Innengewindes 12 oder zusätzlich zum Innengewinde 12 kann natürlich auch eine Versenkung zur Positionierung einer Senkschraube analog zu Fig. 1 vorgesehen sein.

Fig. 10 zeigt deutlich, wie ein Solarmodulverbund 4, der bereits mit benachbarten Teilen 3 des Rahmens versehen ist und der an der Oberseite ein Glas 14 aufweist, mit Aussparungen 15 versehen werden muß, damit ein Eckwinkel 2 eingepaßt werden kann. Die Aussparungen 15 können dabei durch Ausklinken, Ausschneiden, Ausstanzen usw. erzeugt werden. Die Aussparungen 15 sind deshalb notwendig, damit ein Stift durch das Befestigungsloch 5 hindurchgesteckt werden kann.

Ein Solarmodulverbund 4 muß nicht unbedingt ein Glas 14 aufweisen. Die Erfindung ist für beliebige Solarmodule anwendbar, die an ihrer Außenseite einen aus mehreren Teilen zusammensetzbaren Rahmen aufweisen.

In den Fig. 7 und 8 besitzt der Eckwinkel 2 einen Fuß 16, der in den Eckwinkel 2 integriert ist und als Abstandshalter zur Unterlage des Solarmoduls dient.

Durch diesen Fuß 16 hindurch erstreckt sich das Befestigungsloch 5. Dieser Fuß 16 kann alternativ auch einen Befestigungsstift aufweisen.

Wenn mehrere Solarmodule abstandslos nebeneinander angeordnet sind, ist es vorteilhaft, daß der Eckwinkel 2 Wasserablauf-Öffnungen 18 aufweist. Solche Öffnungen 18 können gebohrt werden oder in Form von Schlitzen oder in sonstiger Weise bereits beim Gießen des Eckwinkels 2 mithergestellt werden.

Der Eckwinkel 2 kann aus Aluminiumdruckguß hergestellt werden.

Das Glas 14 ist mit Hilfe einer Gummidichtung im Rahmen, der von den Teilen 3 und den Eckwinkeln 2 gebildet wird, gehaltert. Die in Fig. 10 in der Aussparung 15 gezeigte Nut in dieser Gummidichtung ist für die Erfindung ohne Bedeutung.

**Patentansprüche**

1. Solarmodul mit einem Rahmen, der aus mehreren Teilen zusammengesetzt ist, der ein Profil aufweist, und bei dem Bohrungen zur Befestigung des Solarmoduls an den Ecken des Rahmens senkrecht Zur Ebene des Solarmoduls durch den gesamten Rahmen hindurch vorgesehen sind,

   **dadurch gekennzeichnet,** daß zwischen mindestens zwei benachbarten länglichen Teilen (3) des Rahmens ein Eckwinkel (1) vorgesehen ist, der eine Bohrung (5) senkrecht zur Ebene des Solarmoduls durch den gesamten Eckwinkel hindurch zum Befestigen des Solarmoduls aufweist, daß der Eckwinkel zwei Einrichtungen (11) zur Halterung des Eckwinkels in den diesem Eckwinkel benachbarten länglichen Teilen (3) des Rahmens aufweist, so daß der Winkel, den die beiden dem Eckwinkel benachbarten länglichen Teile (3) des Rahmens miteinander bilden, dadurch festgelegt ist, und daß der Eckwinkel einen Flansch aufweist, der gegenüber dem Rahmen aufträgt.

2. Solarmodul mit einem Rahmen, der aus mehreren Teilen zusammengesetzt ist, der ein Profil aufweist, und bei dem Bohrungen zur Befestigung des Solarmoduls an den Ecken des Rahmens senkrecht zur Ebene des Solarmoduls durch den gesamten Rahmen hindurch vorgesehen sind,

   **dadurch gekennzeichnet,** daß zwischen mindestens zwei benachbarten länglichen Teilen (3) des Rahmens ein Eckwinkel (2) vorgesehen ist, der eine Bohrung (5) senkrecht zur Ebene des Solarmoduls durch den gesamten Eckwinkel hindurch zum Befestigen des Solarmoduls aufweist, daß der Eckwinkel zwei Einrichtungen (13) zur Halterung des Eckwinkels in den diesem Eckwinkel benachbarten länglichen Teilen (3) des Rahmens aufweist, so daß der Winkel, den die beiden dem Eckwinkel benachbarten länglichen Teile (3) des Rahmens miteinander bilden, dadurch festgelegt ist, daß eine Ecke des Solarmodulverbunds (4) zwischen den benachbarten Teilen (3) der Rahmens eine Aussparung (15) aufweist und daß dadurch der Eckwinkel so angeordnet ist, daß er gegenüber dem Rahmen nicht aufträgt.

3. Solarmodul nach Anspruch 1 oder 2, **dadurch gekennzeichnet,** daß die Einrichtungen (11, 13) zur Halterung des Eckwinkels (1, 2) mit Stellschrauben in den Teilen (3) des Rahmens fixiert sind.

4. Solarmodul nach einem der Ansprüche 1 bis 3, **dadurch gekennzeichnet,** daß der Eckwinkel (1, 2) wenigstens an einem der Einrichtungen (11, 13) zur Halterung des Eckwinkels ein Innengewinde (6, 12) zum Befestigen des Eckwinkels an den Teilen (3) des Rahmens besitzt.

5. Solarmodul nach einem der Ansprüche 2, 3, 4 **dadurch gekennzeichnet,** daß der Eckwinkel (2) Einrichtungen (18) zum Ablaufen von Wasser aufweist.

6. Solarmodul nach einem der Ansprüche 2, 3, 4, 5, **dadurch gekennzeichnet,** daß der Eckwinkel (2) wenigstens einen Abstandshalter (16) aufweist.

## Claims

1. Solar module having a frame, which is composed of a plurality of parts and has a profile, and in which bores are provided perpendicular to the plane of the solar module through the entire frame for the purpose of mounting the solar module using the corners of the frame, characterised in that there is provided between at least two adjacent elongated parts (3) of the frame an angle bracket (1) which has a bore (5) perpendicular to the plane of the solar module through the entire angle bracket for the purpose of mounting the solar module, and in that the angle bracket has two devices (11) for holding the angle bracket in the elongated parts (3), adjacent to this angle bracket, of the frame, so that the angle which the two elongated parts (3), adjacent to the angle bracket, of the frame form with one another is thereby fixed, and in that the angle bracket has a flange that is bulky with respect to the frame.

2. Solar module having a frame, which is composed of a plurality of parts and has a profile, and in which bores are provided perpendicular to the plane of the solar module through the entire frame for the purpose of mounting the solar module using the corners of the frame, characterised in that there is provided between at least two adjacent elongated parts (3) of the frame an angle bracket (2) which has a bore (5) perpendicular to the plane of the solar module through the entire angle bracket for the purpose of mounting the solar module, and in that the angle bracket has two devices (13) for holding the angle bracket in the elongated parts (3), adjacent to this angle bracket, of the frame, so that the angle which the two elongated parts (3), adjacent to the angle bracket, of the frame from with one another is thereby fixed, and in that one corner of the compound solar module (4) between the adjacent parts (3) of the frame has a recess (15), and in that the angle bracket is thereby so arranged that it is not bulky with respect to the frame.

3. Solar module according to Claim 1 or 2, characterised in that the devices (11, 13) for holding the angle bracket (1, 2) are fixed by means of adjusting screws in the parts (3) of the frame.

4. Solar module according to one of Claims 1 to 3, characterised in that at least on one of the devices (11, 13) for holding the angle bracket (1, 2), the angle bracket has an internal thread (6, 12) for mounting the angle bracket on the parts (3) of the frame.

5. Solar module according to one of Claims 2, 3, 4 characterised in that the angle bracket (2) has devices (18) for discharging of water.

6. Solar module according to one of Claims 2, 3, 4, 5, characterised in that the angle bracket (2) has at least one spacer (16).

## Revendications

1. Module solaire comportant un cadre formé par l'assemblage de plusieurs éléments et possédant un profil, et dans lequel des percages servant à fixer le module solaire sont prévus à travers l'ensemble du cadre au niveau des sommets de ce dernier, perpendiculairement au plan du module solaire, caractérisé par le fait qu'entre au moins deux éléments allongés voisins (3) du cadre, il est prévu une cornière d'angle (1), qui possède un perçage (5) qui traverse l'ensemble de la cornière d'angle, perpendiculairement au plan du module solaire, pour la fixation de ce dernier, que la cornière d'angle comporte deux dispositifs (11) servant à la maintenir dans les éléments allongés (3) du cadre, qui sont voisins de cette cornière d'angle, de sorte que l'angle, que forment entre eux les deux éléments allongés (3) du cadre, voisins de la cornière d'angle, est de ce fait fixé et que la cornière d'angle possède une bride qui fait saillie par rapport au cadre.

2. Module solaire comportant un cadre formé par l'assemblage de plusieurs éléments et possédant un profil, et dans lequel des perçages servant à fixer le module solaire sont prévus à travers l'ensemble du cadre au niveau des sommets de ce dernier, perpendiculairement au plan du module solaire,
caractérisé par le fait qu'entre au moins deux éléments allongés voisins (3) du cadre, il est prévu une cornière d'angle (2), qui possède un perçage (5) qui traverse l'ensemble de la cornière d'angle, perpendiculairement au plan du module solaire, pour la fixation de ce dernier, que la cornière d'angle comporte deux dispositifs (13) servant à la maintenir dans les éléments allongés (3) du cadre, qui sont voisins de cette cornière d'angle, de sorte que l'angle, que forment entre eux les deux éléments allongés (3) du cadre, voisins de la cornière d'angle, est de ce fait fixé et qu'un angle de la structure composite (4) du module solaire possède un évidement (15) entre les éléments voisins (3) du cadre et que la cornière d'angle est disposée de telle sorte qu'elle ne fait pas saillie par rapport au cadre.

3. Module solaire suivant la revendication 1 ou 2, caractérisé par le fait que les dispositifs (11,13) servant à maintenir la cornière d'angle (1,2) sont fixés aux éléments (3) du cadre par des vis de fixation.

4. Module solaire suivant l'une des revendications 1 à 3, caractérisé par le fait que la cornière d'angle (1,2) possède, pour sa fixation, au moins dans l'un des dispositifs (11,13), un taraudage (6,12) permettant de fixer la cornière d'angle sur les éléments (3) du cadre.

5. Module solaire suivant l'une des revendications 2, 3, 4, caractérisé par le fait que la cornière d'angle (2) comporte des dispositifs (18) permettant d'évacuer l'eau.

6. Module solaire suivant l'une des revendications 2, 3, 4, 5, caractérisé par le fait que la cornière d'angle (2) possède au moins une entretoise (16).

## FIG 1

## FIG 3

## FIG 2

## FIG 4

FIG 5

FIG 9

FIG 6

FIG 7

FIG 8

FIG 10